# FASCICULE DE BREVET EUROPEEN

(11) **EP 1 902 154 B1**
(45) Date de publication et mention de la délivrance du brevet: **15.12.2010**
(21) Numéro de dépôt: 06778870.3
(22) Date de dépôt: 12.07.2006
(51) Int. Cl.: C23C 16/04, C23C 16/52

(54) **APPAREIL POUR LE DEPOT PECVD D'UNE COUCHE BARRIERE INTERNE SUR UN RECIPIENT, COMPRENANT UN DISPOSITIF D'ANALYSE OPTIQUE DU PLASMA**
VORRICHTUNG ZUR PEVCD-ABSCHEIDUNG EINER INNENBARRIERESCHICHT AUF EINEM BEHÄLTER, UMFASSEND EINE VORRICHTUNG ZUR OPTISCHEN PLASMAANALYSE
APPARATUS FOR THE PECVD DEPOSITION OF AN INNER BARRIER LAYER ON A CONTAINER, COMPRISING AN OPTICAL PLASMA ANALYSIS DEVICE

(30) Priorité: 13.07.2005 FR 0507555
(43) Date de publication de la demande: 26.03.2008
(73) Titulaire: Sidel Participations, 76930 Octeville Sur Mer (FR)
(72) Inventeur: RIUS, Jean-Michel c/o Sidel Participations, 76930 Octeville-sur-Mer (FR); FEUILLOLEY, Guy c/o Sidel Participations, 76930 Octeville-sur-Mer (FR)
(74) Mandataire: Cabinet Plasseraud
(86) Numéro de dépôt international: PCT/FR2006/001703
(87) Numéro de publication internationale: WO 2007/006977

(56) Documents cités:
- EP-A- 1 500 600
- DE-A1- 10 341 513
- FR-A- 1 541 499
- US-A- 4 407 709
- PATENT ABSTRACTS OF JAPAN vol. 010, no. 321 (C-382), 31 octobre 1986 (1986-10-31) & JP 61 130485 A (MITSUBISHI ELECTRIC CORP), 18 juin 1986 (1986-06-18)
- PATENT ABSTRACTS OF JAPAN vol. 011, no. 300 (C-449), 29 septembre 1987 (1987-09-29) & JP 62 093382 A (MITSUBISHI ELECTRIC CORP), 28 avril 1987 (1987-04-28)
- PATENT ABSTRACTS OF JAPAN vol. 2003, no. 12, 5 décembre 2003 (2003-12-05) & JP 2004 137556 A (RENESAS TECHNOLOGY CORP), 13 mai 2004 (2004-05-13)

## Description

L'invention a trait à la fabrication des récipients, et plus particulièrement des récipients en polymère, revêtus, sur une paroi interne, d'une couche comprenant un matériau à effet barrière.

Une telle couche, par exemple en carbone amorphe hydrogéné, de type dur (DLC : Diamond like carbon) ou mou (PLC : polymer like carbon) est classiquement formée par dépôt par plasma activé en phase vapeur (PECVD : Plasma Enhanced Chemical Vapor Deposition). Cette technologie est bien explicitée dans le brevet européen N° EP 1 068 032 au nom de la demanderesse, ou encore dans le brevet américain N° US 5 522 351.

Plusieurs types de réaction peuvent, au choix, être mises en oeuvre, tout dépendant du matériau que l'on souhaite déposer sur la paroi interne du récipient.

Dans le cas par exemple d'un carbone mou (PLC), on utilise de préférence comme gaz précurseur de l'acétylène (C₂H₂) que l'on introduit dans le récipient, où un vide partiel (0,1 mbar environ) a préalablement été fait, puis on active le plasma, c'est-à-dire que l'on fait passer l'acétylène à l'état de plasma froid, au moyen d'une excitation électromagnétique micro-onde UHF (2,45 GHz) de faible puissance. Parmi les espèces générées se trouve du carbone hydrogéné (avec liaisons CH, CH₂ et CH₃) qui se dépose en couche mince (d'une épaisseur de 1600 Angströms environ) sur le substrat polymère formé par la paroi interne du récipient.

Il est en pratique difficile de contrôler les espèces générées dans le plasma, dont la composition dépend en grande partie des conditions opératoires (temps de réaction, température, pression, puissance des micro-ondes, etc.). Il a été constaté que des espèces non souhaitables pour un bon revêtement (par exemple l'oxygène ou l'azote) font parfois leur apparition. Il s'avère alors nécessaire de se débarrasser du récipient incriminé. Pour effectuer le contrôle qualité des récipients, on contrôle de manière systématique (c'est-à-dire pour chaque récipient) le plasma lui-même. Ce contrôle est généralement optique. Ainsi, dans le brevet américain précité N° US 5 522 351, une sonde, reliée par fibre optique à un spectromètre, est placée au sein du récipient pour contrôler le plasma in situ. Grâce au spectromètre, on est censé détecter la présence dans le plasma de telle ou telle espèce, caractérisée par une raie particulière. Toutefois, en réalité, le dépôt généré par le plasma affecte la qualité de la mesure. De fait, comme cela est indiqué dans ce brevet, la mesure ne peut, dans le contexte qui vient d'être décrit, être effectuée que dans le cas où le dépôt n'affecte pas la sonde.

Le document EP 1 500 600 décrit aussi un type d'appareil similaire.

Dans le cas d'un dépôt carboné, l'utilisation d'un tel montage est à éviter : après quelques itérations la sonde est en effet polluée par le dépôt de carbone qui rend les mesures inexploitables.

Une pratique répandue consiste, pour éviter les problèmes de pollution, à placer un capteur, relié à un spectromètre, en dehors de la zone de présence du plasma et d'observer celui-ci au-travers du récipient et de la paroi de l'enceinte dans laquelle celui-ci est disposé (cette enceinte comprend généralement une paroi cylindrique en quartz dans laquelle règne le vide partiel évoqué ci-dessus). Toutefois, un traitement du signal extrêmement minutieux doit être accompli à partir des données brutes récoltées par le capteur, pour s'affranchir des interférences produites par les matériaux traversés par les photons provenant du plasma, notamment le polymère du récipient et le quartz de l'enceinte, et déduire de ces données brutes la nature des espèces présentes dans le plasma.

C'est pourquoi le besoin se fait toujours ressentir d'un montage permettant d'analyser le plasma en s'affranchissant des problèmes évoqués ci-dessus.

A cet effet, l'invention propose un appareil pour le dépôt par plasma activé en phase vapeur (PECVD) d'une couche mince d'un matériau à effet barrière sur une paroi interne d'un récipient, cet appareil étant défini par l'une quelconque des revendications 1 à 6.

Suivant un mode de réalisation, l'appareil comporte un tube. Il peut s'agir d'un injecteur tubulaire traversant le col du récipient pour l'introduction dans celui-ci d'un gaz précurseur, et qui présente une ouverture interne débouchant dans le récipient.

Suivant un autre mode de réalisation, le bâti peut comporter un orifice qui est pratiqué dans une grille de confinement d'une zone de post-décharge extérieure au récipient.

Dans ce cas, l'appareil comprend par exemple un système d'aspiration des gaz issus du plasma au travers de ladite grille.

D'autres objets et avantages de l'invention apparaîtront à la lumière de la description faite ci-après en référence aux dessins annexés dans lesquels :
- la figure 1 est une vue d'élévation en coupe montrant un appareil suivant un premier mode de réalisation de la présente invention ;
- la figure 2 est une vue d'élévation en coupe montrant un appareil suivant un deuxième mode de réalisation de la présente invention ;
- la figure 3 est une vue schématique d'élévation en coupe montrant un appareil suivant un troisième mode de réalisation de la présente invention.

Sur les figures est représenté un appareil 1 pour le dépôt par plasma activé en phase vapeur (PECVD) d'une couche mince d'un matériau à effet barrière sur une paroi interne 2 d'un récipient 3 muni d'un col 4 définissant par exemple un buvant.

Le récipient 3 est formé, préalablement aux opérations de PECVD, par exemple par soufflage ou par étirage-soufflage ; il est en l'occurrence réalisé dans un matériau polymère tel que PET.

Cet appareil 1 comporte un bâti 5 destiné à recevoir le récipient 3. Ce bâti 5 comprend une cavité 6 sensiblement cylindrique, à parois conductrices, par exemple métalliques, qui renferme une enceinte 7 définie par une paroi cylindrique réalisée dans un matériau transparent aux micro-ondes électromagnétiques, par exemple en quartz, enceinte dans laquelle est placé le récipient 3 à traiter.

Le bâti 5 comprend également une culasse 8 ajourée, surmontant la cavité 6, et qui définit, à l'aplomb de l'enceinte 7, une zone 9 de post-décharge reliée à une évacuation 10.

Le bâti 5 comprend en outre un couvercle 11 surmontant la culasse 8 et fermant la zone 9 de post-décharge à l'opposé de l'enceinte 7.

L'appareil 1 comprend par ailleurs un générateur de micro-ondes électromagnétiques, relié à la cavité 6 par un guide d'ondes 12 partiellement représenté sur les figures.

Le récipient 3 est suspendu par son col 4 dans l'enceinte 7 par l'intermédiaire d'un bloc support 13 muni de joints assurant l'étanchéité entre le récipient 3 et la culasse 8.

L'appareil 1 est équipé d'une pompe à vide (non représentée) reliée d'une part à l'intérieur de l'enceinte 7 et d'autre part à l'intérieur du récipient 3 via la zone 9 de post-décharge.

L'appareil 1 comprend en outre un injecteur 14 tubulaire qui s'étend verticalement au travers du couvercle 11 et de la culasse 8 en transitant par la zone 9 de post-décharge pour aboutir dans le récipient 3. L'injecteur 14 présente une extrémité interne inférieure définissant une ouverture interne 15 qui débouche dans le récipient 3, et une extrémité interne supérieure opposée définissant une ouverture externe 16, qui débouche à l'extérieur du bâti 5. L'injecteur 14 présente un axe A1, qui est l'axe de symétrie de révolution de la surface interne délimitant le passage central de l'injecteur 14, et cet axe A1 est confondu avec un axe vertical de symétrie générale du récipient 3 lorsque celui-ci est reçu dans l'enceinte 7.

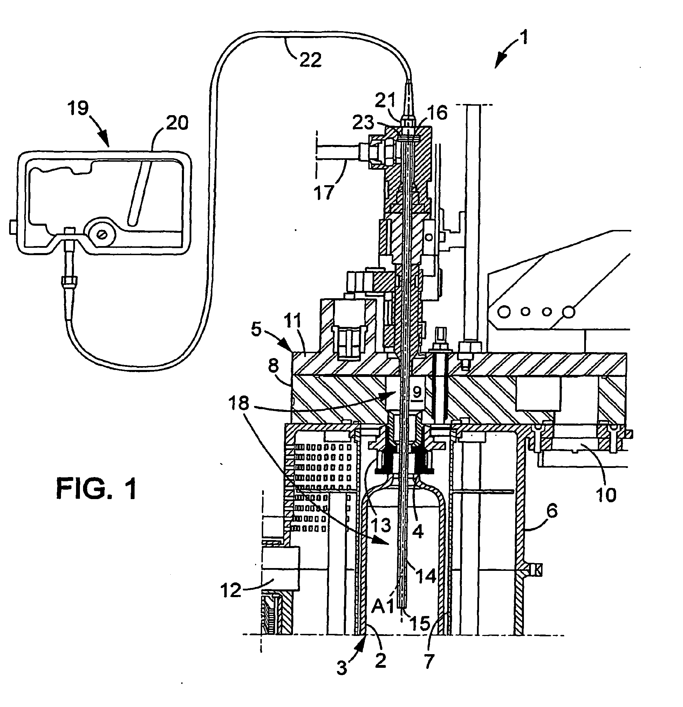

L'injecteur 14, rendu solidaire du couvercle 11 qu'il traverse, et ainsi intégré au bâti 5 comme représenté sur la figure 1, est relié, à proximité de son extrémité supérieure (ouverture externe 16), à une arrivée 17 de gaz précurseur, tel que de l'acétylène.

Le traitement du récipient 3 en vue de la formation d'une couche barrière interne est effectué comme suit.

Une fois le récipient 3 en place dans l'enceinte 7, on commence par faire un vide partiel (d'environ 0,1 mbar) à la fois dans le récipient 3 et dans l'enceinte 7, de manière à maintenir un équilibre de pression de part et d'autre de la paroi du récipient 3.

On balaye ensuite l'intérieur du récipient 3 au moyen du gaz précurseur, via l'injecteur 14. On génère ensuite un flux de micro-ondes électromagnétiques UHF à 2,5 GHz de faible puissance (quelques centaines de Watts), grâce auquel on active dans le gaz précurseur injecté un plasma froid (Ce qui provoque une faible élévation de température, inférieure à la température de transition vitreuse du polymère dans lequel est réalisé le récipient 3).

Le plasma envahit une zone 18, appelée zone de présence du plasma, incluant le volume interne du récipient 3 et la zone 9 de post-décharge définie par la culasse 8. Le flux de micro-ondes est maintenu pendant une durée de quelques secondes (par exemple de l'ordre de 3 secondes), au cours de laquelle les espèces formées dans le plasma se déposent sur la paroi interne 2 du récipient 3 pour former une mince couche de carbone amorphe hydrogéné, de type PLC. Puis le flux de micro-ondes est stoppé, et le gaz issu du plasma est aspiré vers l'évacuation 10.

Tout au long du processus, on analyse le plasma afin de vérifier son homogénéité et de détecter quelles espèces sont générées pour éventuellement prendre les mesures qui s'imposent (telle que l'éjection du récipient 3) lorsque parmi ces espèces se trouve une - ou plusieurs - espèce non désirée (par exemple l'oxygène ou l'azote).

A cet effet, l'appareil 1 comporte un dispositif 19 de contrôle optique du plasma, qui comporte un spectromètre 20 ainsi qu'un capteur 21 placé à l'extérieur de la zone 18 de présence de plasma et relié au spectromètre 20, par exemple via une fibre optique 22.

Suivant un premier mode de réalisation, illustré sur la figure 1, le capteur 21 est placé à l'extrémité supérieure de l'injecteur 14, en regard de l'ouverture externe 16, dans l'axe A1 de l'injecteur, de manière à être en contact optique direct avec l'intérieur du récipient 3.

Plus précisément, entre le capteur 21 et l'ouverture externe 16, à l'extrémité supérieure de l'injecteur 14, est interposé, de manière étanche, un hublot 23 réalisé dans un matériau à large bande passante (c'est-à-dire transmettant une grande partie, voire la totalité du spectre lumineux), par exemple en silice UV.

Compte tenu de la direction du flux de gaz précurseur dans l'injecteur 14, en direction du récipient 3, le hublot 23 ne subit aucune pollution par les espèces générées. En d'autres termes, aucun dépôt carboné ne se forme sur le hublot 23. Par contre, des photons générés par le plasma remontent l'injecteur 14 (d'un diamètre intérieur compris entre 4 et 5 mm environ) et atteignent le capteur 21 au travers du hublot 23 : le montage permet ainsi d'observer optiquement le plasma, le spectromètre 20 permettant ensuite d'en conduire l'analyse.

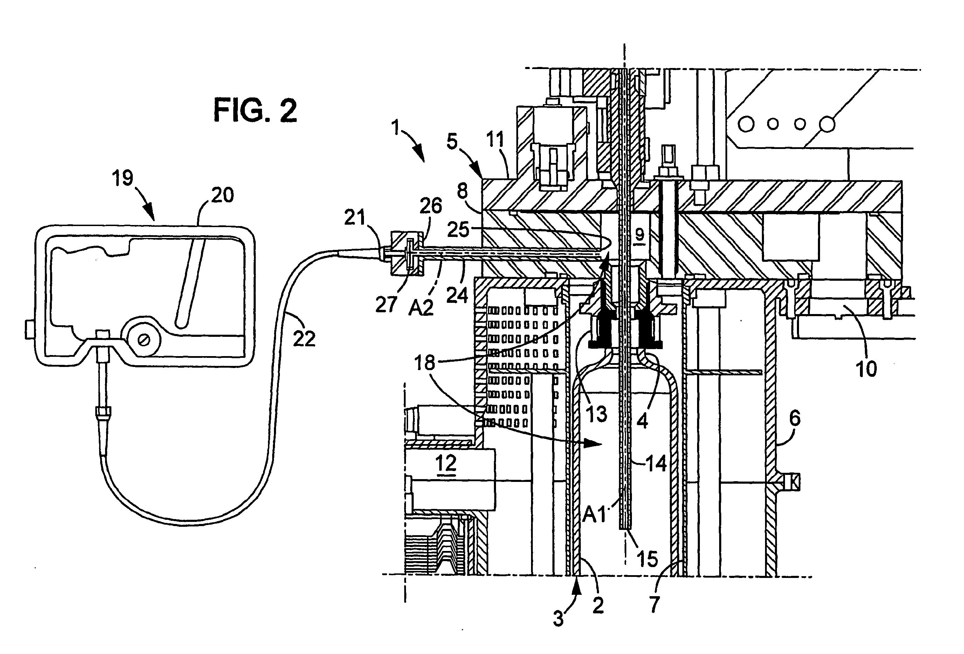

Suivant un deuxième mode de réalisation, illustré sur la figure 2, l'appareil 1 comprend un tube 24 rapporté sur et traversant transversalement la culasse 8. Ce tube 24, ainsi intégré au bâti, et qui définit un axe A2 (axe de symétrie de révolution de la surface interne du tube 24) sensiblement perpendiculaire à l'axe A1, présente une première extrémité, définissant une ouverture interne 25 qui débouche dans la zone 9 de post-décharge du côté opposé à l'évacuation 10, et une seconde extrémité opposée qui définit une ouverture externe 26 débouchant à l'extérieur du bâti 5.

Comme cela est visible sur la figure 2, le capteur 21 est monté à proximité de l'ouverture externe 26 à la seconde extrémité du tube 24, dans l'axe A2 de celui-ci, de manière à être en contact optique direct avec la zone 9 de post-décharge, laquelle est envahie par le plasma lors de l'activation de celui-ci. Comme dans le premier mode de réalisation, un hublot 27 à large bande passante est interposée entre le capteur 21 et l'ouverture externe 26 du tube 24.

De la sorte, comme dans le premier mode de réalisation décrit ci-dessus, on observe directement le plasma, l'analyse optique de celui-ci étant effectuée au moyen du spectromètre 20.

Le dépôt d'espèces sur le hublot 27 est limité, d'une part, par le fait que le diamètre du tube 24 est faible devant les dimensions en section de la zone 9 de post-décharge et de l'évacuation 10 (dans le mode de réalisation illustré, le diamètre interne du tube 24 est compris entre 4 et 5 mm environ) et, d'autre part, par le fait qu'une fois stoppé le flux de micro-ondes, l'aspiration des gaz issus du plasma établit un courant fluidique dirigé depuis l'intérieur du récipient 3 et la zone 9 de post-décharge vers l'évacuation 10, c'est-à-dire à l'opposé du tube 24.

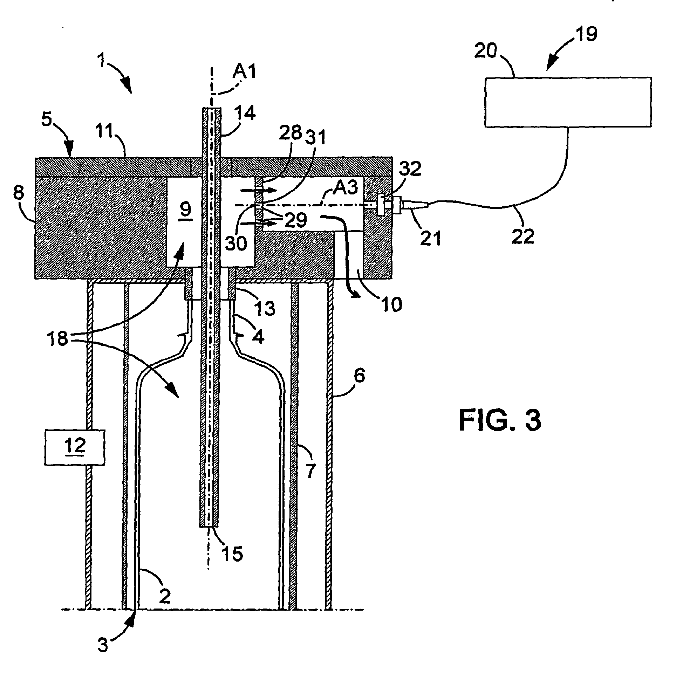

Suivant un troisième mode de réalisation, illustré sur la figure 3, la zone 9 de post-décharge est bordée d'une grille 28 qui confine le plasma dans cette zone 9 tout en mettant celle-ci en communication avec l'évacuation 10. La grille 28 présente une pluralité de trous 29 au-travers desquels passent les gaz issus du plasma, sous l'effet d'un courant fluidique (matérialisé par des flèches sur la figure 3) généré par un système (non représenté) d'aspiration des gaz.

La grille 28 est par exemple disposée sensiblement parallèlement à l'axe A1 du récipient 3. Chacun de ses trous 29 présente une ouverture interne 30, qui débouche dans la zone 9 de post-décharge, et une ouverture externe 31 opposée (qui débouche vers l'évacuation 10). Chaque trou 29 définit un axe A3 (axe de symétrie de révolution de la surface délimitant le trou 29) localement perpendiculaire à la grille (et donc sensiblement perpendiculaire à l'axe du récipient).

Comme cela est représenté sur la figure 3, le capteur 21 est intégré dans la culasse 8 dans l'axe A3 de l'un des trous 29, de manière à être en contact optique direct avec la zone 9 de post-décharge, éventuellement avec interposition d'un hublot 32 comme dans les deux premiers modes de réalisation. La grille 28 ayant une fonction de confinement du plasma, le hublot 32 n'est pas atteint par celui-ci, de sorte qu'aucun dépôt d'espèces ne peut s'y former, qui serait susceptible d'interférer sur les mesures.

Ainsi, quel que soit le mode de réalisation retenu parmi les trois qui viennent d'être décrits, l'appareil 1 est muni d'un orifice (dans le premier mode de réalisation, cet orifice est constitué par l'injecteur 14 tubulaire, dans le second par le tube 24 rapporté et dans le troisième par l'un des trous 29 dans la grille 28 de confinement) au travers duquel on observe le plasma au moyen du capteur 21 orienté dans l'axe A1, A2 ou A3 de 1' orifice en direction de la zone 18 de présence du plasma, l'analyse de celui-ci étant effectuée au moyen du spectromètre 20.

Une telle disposition permet d'analyser le plasma tout en évitant (ou en limitant) le risque qu'un dépôt d'espèces issues du plasma ne fausse les mesures relevées par le capteur 21. La pertinence de l'analyse du plasma s'en trouve accrue, au bénéfice notamment de la qualité des récipients traités.

## Revendications

1. Appareil (1) pour le depôt par plasma activé en phase vapeur (PECVD) d'une couche mince d'un matériau à effet barrière sur une paroi interne (2) d'un récipient (3), cet appareil (1) comprenant:
- un bâti (5,6,8,11) recevant le récipient (3) et une zone (9,18) de présence du plasma, ce bâti (5,6,8,11) étant traversé par un tube (14) comprenant un axe (A1), et présentant une ouverture
interne (15) débouchant dans la zone (18) de présence du plasma définie par le volume interne du récipient (3), et une ouverture externe (16) débouchant à l'extérieur de cette zone (18) définie par le volume interne du récipient (3);
- un générateur d'ondes électromagnetiques pour l'activation du plasma ; et
- un dispositif (19) de contrôle optique du plasma, qui comporte un spectromètre (20) et un capteur (21) placé à l'extérieur de la zone (9,18) de présence de plasma et relié au spectrométre (20) ;
appareil **caractérisé en ce que** ledit capteur (21) est placé dans l'axe (A1) dudit tube (14), de manière à être en contact optique direct avec la zone (18) de présence du plasma définie par le volume interne du récipient (3).

2. Appareil (1) selon la revendication 1, **caractérisé en ce que**, ledit récipient (3) étant muni d'un col (4), ledit tube (14) est un injecteur (14) tubulaire traversant ledit col (4) pour l'introduction dans le récipient (3) d'un gaz précurseur, cet injecteur (14) présentant une ouverture interne (15) débouchant dans le récipient (3).

3. Appareil (1) pour le depôt par plasma activé en phase vapeur (PECVD) d'une couche mince d'un matériau à effet barrière sur une paroi interné (2) d'un récipient (3), cet appareil (1) comprenant:
- un bâti (5,6,8,11) recevant le récipient (3) et une zone (9,18) de présence du plasma, ce bâti (5,9,8,11) étant traversé par un tube (24) comprenant un axe (A2) et présentant une ouverture
interne (25) débouchant dans la zone (9) de post-décharge du plasma extérieure au récipient (3), et une ouverture externe (26) débouchant à l'extérieur de cette zone (9) de post-décharge du plasma;
- un générateur d'ondes électromagnetiques pour l'activation du plasma ; et
- un dispositif (19) de contrôle optique du plasma, qui comporte un spectromètre (20) et un capteur (21) placé à l'extérieur de la zone (9,18) de présence de plasma et relié au spectrométrie (20) ;
appareil **caractérisé en ce que** ledit capteur (21) est place dans l'axe (A2) dudit tube (24), de manière à être en contact optique direct avec la zone (9) de post-décharge du plasma.

4. Appareil (1) pour le depôt par plasma activé en phase vapeur (PECVD) d'une couche mince d'un matériau à effet barrière sur une paroi interne (2) d'un récipient (3), cet appareil (1) comprenant:
- un bâti (5,6,8,11) recevant le récipient (3) et une zone (9,18) de présence du plasma, ce bâti (5,6,8,11) étant muni d'un orifice (29) comprenant un axe (A3) et présentant une ouverture
interne (30) débouchant dans la zone (9) de post-décharge du plasma extérieure au récipient (3), et une ouverture externe (31) débouchant à l'extérieur de cette zone (9) de post-décharge du plasma;
- un générateur d'ondes électromagnetiques pour l'activation du plasma ; et
- un dispositif (19) de contrôle optique du plasma, qui comporte un spectromètre (20) et un capteur (21) place à l'extérieur de la zone (9,18) de présence de plasma et relié au spectrométre (20) ;
appareil **caractérisé en ce que** ledit capteur (21) est placé dans l'axe (A3) dudit orifice (29), de manière à être en contact optique direct avec la zone (9) de post-décharge du plasma.

5. Appareil (1) selon la revendication 4, **caractérisé en ce que** ledit orifice (29) est pratiqué dans une grille (28) de confinement d'une zone (9) de post-décharge du plasma, extérieure au récipient (3).

6. Appareil (1) selon la revendication 5, qui comprend en outre un système d'aspiration des gaz issus du plasma au travers de ladite grille (28).

## Claims

1. Apparatus (1) for plasma-enhanced chemical vapor deposition (PECVD) of a thin layer of barrier-effect material on an inside wall (2) of a receptacle (3), said apparatus (1) comprising:
- a structure (5, 6,8, 11) receiving the receptacle (3) and a plasma-presence zone (9, 18), said structure (5, 6,8, 11) being passed through by a tube (14) comprising an axis (A1), and presenting an inside opening (15) opening out into said plasma-presence zone (18) defined by the internal volume of said receptacle (3), and an outside opening (16) opening out outside said plasma-presence zone (18) defined by the internal volume of said receptacle (3);
- an electromagnetic wave generator for activating the plasma; and
- an optical plasma monitor device (19) comprising a spectrometer (20) and a pick-up (21) placed outside said plasma-presence zone (9, 18) and connected to said spectrometer (20);
apparatus **characterized in that** said pick-up (21) is placed on said axis (A1) of said tube (14) so as to be in direct optical contact with said plasma-presence zone (18) defined by said internal volume of said receptacle (3).

2. Apparatus (1) according to claim 1, **characterized in that** said receptacle (3) being provided with a neck (4), said tube (14) is a tubular (14) injector passing through said neck (4) to introduce a precursor gas into the receptacle (3) , said injector (14) presenting an inside opening (15) opening out inside said receptacle (3).

3. Apparatus (1) for plasma-enhanced chemical vapor deposition (PECVD) of a thin layer of barrier-effect material on an inside wall (2) of a receptacle (3), said apparatus (1) comprising:
- a structure (5, 6,8, 11) receiving said receptacle (3) and a plasma-presence zone (9, 18), said structure (5, 6,8, 11) being passed through by a tube (24) comprising an axis (A2), and presenting an inside opening (25) opening out into the plasma post-discharge zone (9), outside said receptacle (3), and an outside opening (26) opening out outside said plasma post-discharge zone (9);
- an electromagnetic wave generator for activating the plasma; and
- an optical plasma monitor device (19) comprising a spectrometer (20) and a pick-up (21) placed outside said plasma-presence zone (9, 18) and connected to said spectrometer (20);
apparatus (1) **characterized in that** said pick-up (21) is placed on said axis (A2) of said tube (24) so as to be in direct optical contact with said plasma post-discharge zone (9).

4. Apparatus (1) for plasma-enhanced chemical vapor deposition (PECVD) of a thin layer of barrier-effect material on an inside wall (2) of a receptacle (3), said apparatus (1) comprising:
- a structure (5, 6,8, 11) receiving said receptacle (3) and a plasma-presence zone (9, 18), said structure (5, 6,8, 11) being provided with an orifice (29) comprising an axis (A3), and presenting an inside opening (30) opening out into the plasma post-discharge zone (9), outside said receptacle (3), and an outside opening (31) opening out outside said plasma post-discharge zone (9);
- an electromagnetic wave generator for activating the plasma; and
- an optical plasma monitor device (19) comprising a spectrometer (20) and a pick-up (21) placed outside said plasma-presence zone (9, 18) and connected to said spectrometer (20);
apparatus (1) **characterized in that** said pick-up (21) is placed on said axis (A3) of said orifice (29) so as to be in direct optical contact with said plasma post-discharge zone (9).

5. Apparatus (1) according to claim 4, wherein said orifice (29) is formed in a confinement grid (28) of a plasma post-discharge zone (9), outside said receptacle (3).

6. Apparatus (1) according to claim 5, further comprising a system for pumping out the gas derived from the plasma out through said grid (28).

## Patentansprüche

1. Vorrichtung (1) für die plasmaaktivierte chemische Gasphasenabscheidung (PECVD) einer dünnen Schicht eines als Barriere wirkenden Materials auf einer Innenwand (2) eines Behälters (3), wobei die Vorrichtung (1) umfasst:
- ein Gestell (5,6,8,11), das den Behälter (3) aufnimmt und ein Bereich (9,18) vorhandenen Plasmas, wobei das Gestell (5,6,8,11) von einem Rohr (14) durchquert wird, das eine Achse (A1) umfasst, und eine innere Öffnung (15) aufweist, die in den Bereich (18) vorhandenen Plasmas mündet, definiert durch das innere Volumen des Behälters (3), und eine externe Öffnung (16), die sich von diesem Bereich (18), definiert durch das innere Volumen des Behälters (3), nach Außen hin öffnet;
- einen Generator elektromagnetischer Wellen für die Aktivierung des Plasmas; und
- eine Einrichtung (19) zur optischen Kontrolle des Plasmas, die ein Spektrometer (20) umfasst und einen Sensor (21), der außerhalb des Bereichs (9,18) vorhandenen Plasmas angeordnet und mit dem Spektrometer (20) verbunden ist;
wobei die Vorrichtung **dadurch gekennzeichnet ist, dass** der Sensor (21) auf der Achse (A1) des Rohrs (14) in einer Weise angeordnet ist, dass er in direktem optischen Kontakt mit dem Bereich (18) vorhandenen Plasmas steht, definiert durch das innere Volumen des Behälters (3).

2. Vorrichtung (1) nach Anspruch 1, **dadurch gekennzeichnet, dass** der Behälter (3) mit einem Hals (4) ausgestattet ist, wobei das Rohr (14) ein rohrförmiger Injektor (14) ist, der den Hals (4) durchquert, um ein Vorläufergas in den Behälter (3) einzuleiten, wobei der Injektor (14) eine innere Öffnung (15) aufweist, die in den Behälter (3) mündet.

3. Vorrichtung (1) für die plasmaaktivierte chemische Gasphasenabscheidung (PECVD) einer dünnen Schicht eines als Barriere wirkenden Materials auf einer Innenwand (2) eines Behälters (3), wobei die Vorrichtung (1) umfasst:
- ein Gestell (5,6,8,11), das den Behälter (3) aufnimmt und ein Bereich (9,18) vorhandenen Plasmas, wobei das Gestell (5,6,8,11) von einem Rohr (24) durchquert wird, das eine Achse (A2) umfasst, und eine innere Öffnung (25) aufweist, die in den Bereich (9) nachglühenden Plasmas außerhalb des Behälters (3) mündet, und eine externe Öffnung (26), die sich von diesem Bereich (9) nachglühenden Plasmas nach Außen hin öffnet;
- einen Generator elektromagnetischer Wellen für die Aktivierung des Plasmas; und
- eine Einrichtung (19) zur optischen Kontrolle des Plasmas, die ein Spektrometer (20) umfasst und einen Sensor (21), der außerhalb des Bereichs (9,18) vorhandenen Plasmas angeordnet und mit dem Spektrometer (20) verbunden ist;
wobei die Vorrichtung **dadurch gekennzeichnet ist, dass** der Sensor (21) auf der Achse (A2) des Rohrs (24) in einer Weise angeordnet ist, dass er in direktem optischen Kontakt mit dem Bereich (9) nachglühenden Plasmas steht.

4. Vorrichtung (1) für die plasmaaktivierte chemische Gasphasenabscheidung (PECVD) einer dünnen Schicht eines als Barriere wirkenden Materials auf einer Innenwand (2) eines Behälters (3), wobei die Vorrichtung (1) umfasst:
- ein Gestell (5,6,8,11), das den Behälter (3) aufnimmt und ein Bereich (9,18) vorhandenen Plasmas, wobei das Gestell (5,6,8,11) mit einer Öffnung (29) ausgestattet ist, die eine Achse (A3) umfasst, und eine innere Öffnung (30) aufweist, die in den Bereich (9) nachglühenden Plasmas außerhalb des Behälters (3) mündet, und eine externe Öffnung (31), die sich von diesem Bereich (9) nachglühenden Plasmas nach Außen hin öffnet;
- einen Generator elektromagnetischer Wellen für die Aktivierung des Plasmas; und
- eine Einrichtung (19) zur optischen Kontrolle des Plasmas, die ein Spektrometer (20) umfasst und einen Sensor (21), der außerhalb des Bereichs (9,18) vorhandenen Plasmas angeordnet und mit dem Spektrometer (20) verbunden ist;
wobei die Vorrichtung **dadurch gekennzeichnet ist, dass** der Sensor (21) auf der Achse (A3) der Öffnung (29) in einer Weise angeordnet ist, dass er in direktem optischen Kontakt mit dem Bereich (9) nachglühenden Plasmas steht.

5. Vorrichtung (1) nach Anspruch 4, **dadurch gekennzeichnet, dass** die Öffnung (29) in ein den Bereich (9) nachglühenden Plasmas isolierendes Gitter (28) außerhalb des Behälters (3) eingebracht ist.

6. Vorrichtung (1) nach Anspruch 5, die weiterhin eine Absaugvorrichtung für aus dem Plasma ausgetretene Gase durch das Gitter (28) hindurch aufweist.
